# FASCICULE DE BREVET EUROPEEN

(11) **EP 2 129 810 B1**
(45) Date de publication et mention de la délivrance du brevet: **20.07.2016**
(21) Numéro de dépôt: 08787802.1
(22) Date de dépôt: 19.03.2008
(51) Int. Cl.: C23C 14/16, C23C 14/24, C23C 14/56

(54) **PROCÉDÉ DE REVÊTEMENT D'UN SUBSTRAT ET INSTALLATION DE DÉPÔT SOUS VIDE D'ALLIAGE MÉTALLIQUE**
VERFAHREN ZUR BESCHICHTUNG EINES SUBSTRATS UND ANLAGE ZUR METALLLEGIERUNGSBEDAMPFUNG
METHOD FOR COATING A SUBSTRATE AND METAL ALLOY VACUUM DEPOSITION FACILITY

(30) Priorité: 20.03.2007 EP 07290342
(43) Date de publication de la demande: 09.12.2009
(73) Titulaire: ArcelorMittal, 1160 Luxembourg (LU)
(72) Inventeur: CHOQUET, Patrick, F-57050 Longeville les Metz (FR); SILBERBERG, Eric, B-5340 Haltinne (Gesves) (BE); SCHMITZ, Bruno, B-4550 Nandrin (BE); CHALEIX, Daniel, F-57420 Verny (FR)
(74) Mandataire: Domenego, Bertrand
(86) Numéro de dépôt international: PCT/FR2008/000347
(87) Numéro de publication internationale: WO 2008/142222

(56) Documents cités:
- EP-A- 1 174 526
- WO-A1-2005/116290
- BE-A3- 1 010 720
- JP-A- 9 256 157
- JP-A- 11 279 670

## Description

La présente invention concerne un procédé de revêtement en continu d'un substrat et une installation de dépôt sous vide de revêtements formés d'alliages métalliques, tel que par exemple les alliages de zinc et de magnésium, ledit procédé étant plus particulièrement destiné au revêtement de bandes d'acier, sans pour autant y être limité.

On connaît différents procédés permettant de déposer des revêtements métalliques composés d'alliages sur un substrat, telle qu'une bande, d'acier. Parmi ceux-ci, on pourra citer les revêtements au trempé à chaud, l'électrodéposition ou bien encore les différents procédés de dépôt sous vide tels que l'évaporation sous vide ou la pulvérisation magnétron.

On connaît ainsi un procédé d'évaporation sous vide décrit dans WO 02/06558 qui consiste à co-évaporer deux éléments dans une chambre pour mélanger les vapeurs des éléments entre elles avant de procéder au dépôt sur le substrat.

La mise en oeuvre industrielle de ce procédé est cependant difficile et n'est pas envisageable pour une production devant garantir une composition du revêtement stable sur de grandes longueurs du substrat.

Il est également possible de déposer successivement sur le substrat une couche de chacun des éléments constitutifs de l'alliage, puis de procéder à un traitement thermique de diffusion aboutissant à l'obtention d'une couche alliée de composition la plus homogène possible. On peut ainsi réaliser notamment des revêtements de zinc-magnésium qui peuvent avantageusement remplacer les revêtements de zinc pur ou d'autres alliages de zinc.

Ce dépôt successif de chacun des éléments peut notamment se faire par co-évaporation sous vide de chaque élément disposé dans un creuset séparé, comme cela est décrit dans EP 730 045, mais aussi en procédant à un dépôt d'un élément sous vide sur une bande préalablement revêtue d'un autre élément par un procédé classique au trempé.

Cependant, le traitement thermique de diffusion ultérieur peut s'avérer complexe et onéreux, car il implique l'utilisation de grandes quantités de gaz d'inertage pour empêcher toute oxydation du revêtement à haute température, lors du traitement thermique. En outre, afin d'éviter tout risque d'oxydation entre le dépôt du magnésium et le début du traitement de diffusion, il est nécessaire de pratiquer les deux opérations immédiatement à la suite l'une de l'autre, sans exposer la bande à l'air libre.

Ce traitement thermique peut également poser problème pour certains matériaux qui ne sont pas compatibles avec une élévation de température trop importante. On citera notamment les bandes d'acier à durcissement par cuisson (dits à bake-hardening) qui contiennent de fortes quantités de carbone en solution solide, qui ne doit pas être précipité avant que la bande ait été mise en forme par l'utilisateur du matériau.

Par ailleurs, dans ce type de procédé, il est très délicat d'obtenir un revêtement de composition constante sur une grande longueur de substrat, car il convient de contrôler très précisément les épaisseurs de chaque couche au cours du temps.

Enfin, le traitement de diffusion permet certes à l'alliage de se former, mais peut également entraîner la diffusion d'éléments du substrat vers le revêtement, venant ainsi le polluer à l'interface avec le substrat.

Le document EP1174526A1 décrit un procédé de revêtement continu d'un alliage binaire, par exemple de Zn-Mg sous vide avec un jet de vapeur porté à une vitesse sonique. Les proportions relatives de vapeurs sont constantes. Les deux bains respectivement de zinc et de magnésium sont portés à haute température et les vapeurs passent un rétrécissement pour atteindre une vitesse sonique.

Le but de la présente invention est donc de remédier aux inconvénients des procédés et installations de l'art antérieur en mettant à disposition une installation de dépôt sous vide de revêtements formés d'alliages métalliques et un procédé de fabrication d'une bande métallique recouverte d'une couche d'alliage métallique, qui permettent une mise en oeuvre industrielle simple, en peu d'étapes, mais aussi l'obtention d'un revêtement de composition constante, et ce sur des substrats de nature variée.

A cet effet, un premier objet de la présente invention est constitué par un procédé de revêtement d'un substrat (S) selon lequel on dépose en continu sur ledit substrat (S) une couche d'alliage métallique à base de zinc et comprenant une proportion de magnésium prédéterminée comprise entre 4% et 20% en poids, au moyen d'une installation de dépôt sous vide (1,11,21) comprenant un dispositif de revêtement par jet de vapeur (7,17), permettant de projeter sur le substrat (S), à une vitesse sonique, une vapeur obtenue par évaporation d'un bain métallique à base de zinc et comprenant initialement une proportion de magnésium prédéterminée entre 30% et 55% en poids en magnésium, ladite proportion initiale étant maintenue constante au cours du dépôt par le biais de moyens d'ajustement de la composition du bain d'alliage métallique comprenant des moyens d'alimentation des moyens d'évaporation (3,13) en alliage métallique fondu de composition contrôlée.

Le procédé selon l'invention peut également comprendre différentes caractéristiques, prises seules ou en combinaison :
- on dépose en continu sur le substrat une couche d'alliage métallique à base de zinc et comprenant une proportion de magnésium prédéterminée comprise entre 4% et 18% en poids, par évaporation d'un bain d'alliage métallique à base de zinc et comprenant initialement une proportion de magnésium prédéterminée entre 30% et 50% en poids en magnésium, la proportion initiale étant maintenue constante au cours du dépôt,
- les éléments métalliques ont des températures d'évaporation dont l'écart ne dépasse pas 100°C à la pression d'évaporation choisie,
- on dépose une couche d'alliage métallique en une épaisseur comprise entre 0,1 et 20 µm,
- le substrat est une bande métallique et de préférence une bande d'acier,
- la bande métallique est un acier à durcissement par cuisson (bake-hardening),

Un second objet de l'invention est constitué par une installation de dépôt sous vide en continu de revêtements formés d'alliages métalliques comprenant au moins deux éléments métalliques sur un substrat en défilement, comprenant une enceinte de dépôt sous vide et des moyens de défilement du substrat au sein de cette enceinte, selon la revendication 6 ou 7.

L'invention consiste à déposer un alliage métallique de composition donnée sur un substrat par le procédé de revêtement par jet de vapeur à vitesse sonique

Grâce à la différence de pression que l'on crée entre un creuset d'évaporation fermé et la chambre de dépôt, il est possible de générer au travers d'une fente étroite un jet de vapeur métallique dont la vitesse peut être sonique. On pourra se référer au brevet WO 97/47782 pour une description plus complète des détails de ce type de dispositif.

La vapeur alimentant le dispositif de dépôt par JVD provient de l'évaporation sous vide directe d'un bain de l'alliage lui-même, la composition du bain étant maintenue constante au cours du temps.

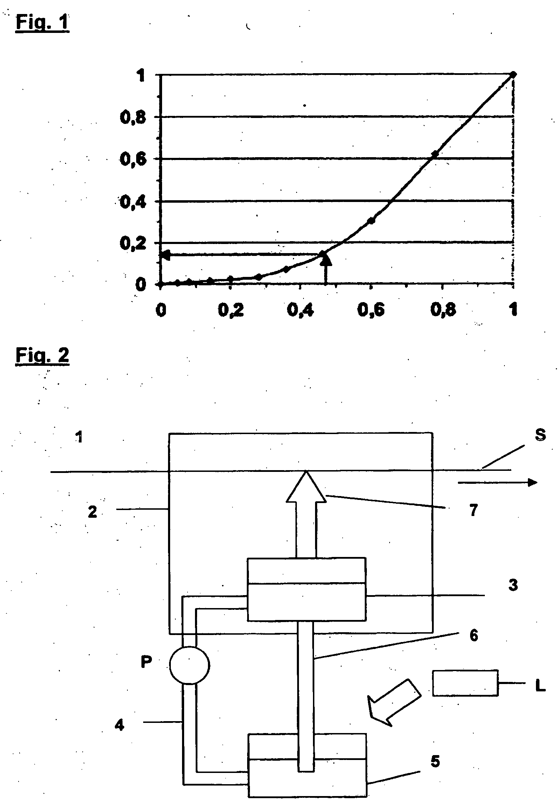

En effet, si on prend l'exemple d'un alliage à base de zinc comprenant du magnésium, chacun de ces deux éléments présente une tension de vapeur différente. La composition de la couche déposée ne sera donc pas la même que celle du lingot utilisé comme matière première de l'évaporation. Ainsi, comme on peut le constater en figure 1, qui représente la teneur en % en poids de magnésium dans le revêtement en ordonnée, en fonction de la teneur en % en poids de magnésium dans le bain, en abscisse, on constate que pour obtenir une teneur de 16% de magnésium dans le revêtement, il est nécessaire d'avoir 48% de magnésium dans le bain métallique.

En raison de cette différence dans les tensions de vapeur des éléments de l'alliage, la composition du bain d'alliage utilisé pour l'évaporation, et de fait, le flux de vapeur correspondant, vont évoluer au cours du temps, avec dans le cas du zinc-magnésium, un enrichissement progressif en magnésium.

Pour maintenir la composition du flux d'évaporation constant au cours du temps, il est nécessaire de prévoir un dispositif permettant de maintenir la composition du bain constante si l'on souhaite pouvoir déposer ce type de revêtement dans le cadre d'une mise en oeuvre industrielle.

D'autres caractéristiques et avantages de l'invention apparaîtront à la lecture de la description qui va suivre, donnée uniquement à titre d'exemple, et se référant aux figures annexées :
- la figure 1 représente la teneur en % en poids de magnésium dans un revêtement en ZnMg en fonction de la teneur en % en poids de magnésium dans le bain de métal liquide avant évaporation,
- la figure 2 représente un premier mode de réalisation d'une installation selon l'invention,
- la figure 3 représente un second mode de réalisation d'une installation selon l'invention,
- la figure 4 représente la microstructure d'un revêtement de 5 µm d'alliage ZnMg déposé sur un acier bas carbone laminé à froid.

La description qui suit se réfèrera à un revêtement d'alliage de zinc comprenant du magnésium, mais il est bien entendu que l'installation selon l'invention ne s'y limite pas et permet le dépôt de nombreux autres revêtements à base d'alliages métalliques.

Un premier mode de réalisation d'une installation selon l'invention est plus particulièrement représenté en figure 2, sur laquelle on peut voir une installation 1 comprenant une enceinte de dépôt sous vide 2. Cette enceinte 2 est de préférence maintenue à une pression comprise entre 10⁻⁸ et 10⁻⁴ bar. Elle comprend un sas d'entrée et un sas de sortie (non représentés), entre lesquels circule un substrat S tel, par exemple, qu'une bande d'acier.

Le défilement du substrat S pourra se faire par tous moyens adaptés, en fonction de la nature et de la forme de celui-ci. On pourra notamment utiliser un rouleau support rotatif sur lequel peut s'appuyer une bande d'acier.

Placé en regard de la face du substrat S devant être revêtu, se trouve une petite chambre d'extraction 7 munie d'une fente étroite, dont la dimension est voisine du format de substrat à revêtir. Cette chambre pourra être réalisée en graphite, par exemple, et peut être montée, directement ou non, sur un creuset d'évaporation 3 qui contient le métal liquide à déposer sur le substrat S. Le rechargement en continu en métal liquide du creuset d'évaporation 3 est assuré par une conduite 4, reliée à un four de fusion 5, placé en contrebas de la chambre d'extraction 7 et se trouvant à pression atmosphérique. Une conduite de surverse 6 relie par ailleurs directement le creuset d'évaporation 3 au four de rechargement 5. Les éléments 3, 4, 5 et 6 sont chauffés à des températures suffisamment hautes pour ne pas avoir de condensation de la vapeur métallique ou de solidification du métal sur leurs parois respectives.

Le creuset d'évaporation 3 et le four de rechargement 5 en métal liquide sont avantageusement munis d'un dispositif de chauffage par induction (non représenté) qui présente l'avantage de faciliter le brassage et l'homogénéisation en composition du bain d'alliage métallique.

Lorsque l'on souhaite faire fonctionner l'installation 1, on détermine préalablement la composition de l'alliage métallique que l'on souhaite déposer sur le substrat, puis l'on détermine la composition du bain permettant d'obtenir en équilibre avec ce bain, une vapeur ayant la composition du revêtement visé. On élabore alors des lingots L d'alliage métallique présentant cette composition précise, que l'on introduit ensuite en continu dans le four de rechargement 5.

Une fois les lingots L fondus, on chauffe le creuset d'évaporation 3 et la conduite 6, puis on réalise le vide dans le creuset d'évaporation 3. Le métal liquide contenu dans le four de rechargement 5, vient alors remplir le creuset d'évaporation 3. Durant le fonctionnement du dispositif, on maintient un niveau de métal liquide constant dans le creuset d'évaporation 3 en réglant la hauteur entre le creuset d'évaporation 3 et le four de rechargement 5 ou en activant une pompe P à métal liquide. Une pompe de circulation installée sur la surverse 6 (non représentée) permet d'assurer un renouvellement permanent du métal liquide dans le creuset d'évaporation 3, afin de minimiser l'accumulation d'impuretés qui après un certain temps diminueraient fortement les vitesses d'évaporation du métal.

On s'assure ainsi que le bain est renouvelé en continu et présente donc en permanence la composition requise en tout point, tout en minimisant la quantité de matière nécessaire au revêtement du substrat.

Le creuset d'évaporation 3 est lui-même muni de moyens de chauffage permettant à la vapeur de se former et d'alimenter un dispositif de revêtement par JVD constitué par la chambre d'extraction 7, qui projette un jet de vapeur sonique sur le substrat S en défilement.

De façon surprenante, il a été constaté que projeter un jet sonique de vapeur métallique sur un substrat permet d'obtenir un revêtement d'alliage AB avec un mélange des éléments A et B à l'échelle nanométrique. Ce résultât est extrêmement important en termes de résistance à la corrosion car dans ce cas, il ne peut pas se former de micro-pile à la surface du revêtement d'alliage AB lorsque celui-ci est en contact avec des condensats liquides.

L'orifice de sortie du jet sonique pourra prendre toute forme adaptée, telle qu'une fente réglable dans sa longueur et sa largeur par exemple. Ce procédé permet ainsi d'adapter facilement la largeur de l'orifice de sortie de la vapeur pour garder un jet sonique dans une large gamme de température de surface du métal évaporé et donc de débit d'évaporation. En outre, la possibilité d'adapter sa longueur à celle du format du substrat à revêtir permet de minimiser les pertes de métal évaporé.

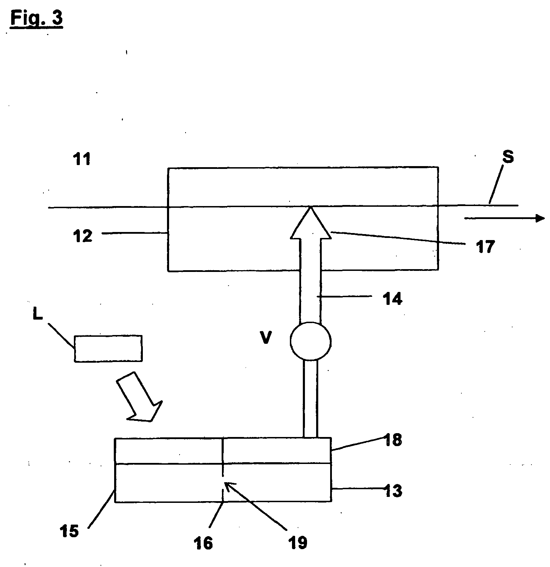

Dans un second mode de réalisation tel que représenté en figure 3, on peut voir une installation 11 comprenant une enceinte de dépôt sous vide 12, analogue à l'enceinte 2. Un creuset d'évaporation 13 est placé sous l'enceinte sous vide 12 et est relié à celle-ci par une conduite 14.

Un four de rechargement 15 est placé à côté du creuset d'évaporation 13, les deux éléments partageant une paroi commune 16 percée d'une ouverture de communication 19, placée sous le niveau du bain d'alliage métallique, mais au-dessus du fond de ces deux éléments afin d'éviter d'introduire dans le creuset d'évaporation 13 des impuretés qui auraient décantées dans le four de rechargement 15.

Le creuset d'évaporation 13 est placé par ailleurs dans une enceinte confinée 18, placée en-dehors de l'enceinte sous vide 12.

La conduite 14 vient alimenter un dispositif de revêtement par JVD 17, analogue au dispositif 7.

De la même façon que précédemment, on détermine au préalable la composition du revêtement que l'on souhaite obtenir sur le substrat, puis l'on en déduit la composition du bain métallique qui doit être présent dans le creuset d'évaporation 13, et donc la composition des lingots métalliques L avec lesquels on doit alimenter le four de rechargement 15.

On les place dans le four de rechargement 15 qui est muni d'un système de chauffage par induction. Au fur et à mesure de sa fusion, l'alliage métallique passe du four de rechargement 15 au creuset d'évaporation 13 par l'ouverture 19. Le creuset d'évaporation 13 est lui-même muni d'un système de chauffage par induction qui permet de générer une vapeur d'alliage métallique présentant la composition requise. Cette vapeur est ensuite acheminée jusqu'au dispositif de dépôt par JVD 17 par la conduite 14, qui est avantageusement munie d'une vanne V de régulation du débit de vapeur.

L'existence d'une ouverture de communication 19 entre le four de rechargement 15 et le creuset d'évaporation 13 permet d'alimenter le creuset d'évaporation 13, mais aussi de réaliser une circulation constante entre ces deux éléments, ce qui permet de garantir le maintien d'une composition constante en tout point du bain contenu par le creuset d'évaporation 13.

Le procédé selon l'invention s'applique plus particulièrement, mais pas uniquement, au traitement de bandes d'acier, préalablement revêtues ou nues. On pourra bien sur employer le procédé selon l'invention à tout substrat revêtu ou non, tel que par exemple des bandes d'aluminium, du verre ou de la céramique.

On l'appliquera en particulier à des substrats susceptibles de voir leurs propriétés détériorées lors d'un traitement thermique de diffusion, tels que les bandes d'acier dits à bake-hardening qui contiennent de fortes quantités de carbone en solution solide, qui ne doit pas être précipité avant d'avoir été mis en forme par emboutissage ou tout autre procédé adapté. La mise en oeuvre du procédé selon l'invention permet ainsi de rendre compatible le dépôt d'alliages métalliques avec la plupart des métallurgies.

Il vise en particulier à l'obtention de revêtements de zinc-magnésium, mais ne se limite pas à ces revêtements et englobe, de préférence, tout revêtement à base d'alliage métallique dont les éléments présentent des températures d'évaporation dont l'écart ne dépasse pas 100°C, car le contrôle de leurs proportions respectives est alors facilité.

On pourra ainsi citer, à titre indicatif, les dépôts de zinc et d'éléments tels que le chrome, le nickel, le titane, le manganèse, l'aluminium.

Par ailleurs, si le procédé et l'installation selon l'invention sont plus particulièrement destinés au dépôt d'alliages métalliques binaires, il va de soi qu'ils peuvent être adaptés au dépôt d'alliages métalliques ternaires, tels que le Zn-Mg-Al, voire au dépôt d'alliages quaternaires, tels que le Zn-Mg-Al-Si, par exemple.

Dans le cas du dépôt de zinc-magnésium, l'épaisseur du revêtement sera de préférence comprise entre 0,1 et 20 µm. En effet, en dessous de 0,1 µm, la protection contre la corrosion du substrat risquerait d'être insuffisante. L'épaisseur du revêtement ne dépasse pas 20 µm, car il n'est pas nécessaire d'aller au-delà pour avoir le niveau de résistance à la corrosion requis dans l'automobile ou le bâtiment, notamment. On pourra généralement se limiter à une épaisseur de 5 µm pour des applications dans l'automobile.

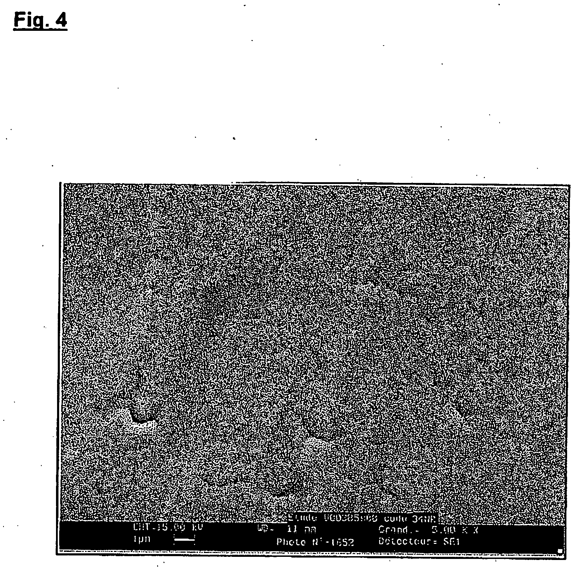

La réalisation d'essais industriels montre que le dépôt par ce procédé permet d'obtenir une vitesse de dépôt élevée, un revêtement de 5µm d'alliage ZnMg pouvant être déposé sur une ligne qui défile à 10 m/min et avec un rendement matière supérieur à 98% grâce à l'orientation ciblée du jet. En outre, les couches de revêtement obtenues présentent une excellente compacité due à une énergie de vapeur plus élevée. La figure 4 montre ainsi la microstructure d'un revêtement de 5µm d'alliage ZnMg déposé sur un acier bas carbone laminé à froid.

## Revendications

1. Procédé de revêtement d'un substrat (S) selon lequel on dépose en continu sur ledit substrat (S) une couche d'alliage métallique à base de zinc et comprenant une proportion de magnésium prédéterminée comprise entre 4% et 20% en poids, au moyen d'une installation de dépôt sous vide (1,11,21) comprenant un dispositif de revêtement par jet de vapeur (7,17), permettant de projeter sur le substrat (S), à une vitesse sonique, une vapeur obtenue par évaporation d'un bain métallique à base de zinc et comprenant initialement une proportion de magnésium prédéterminée entre 30% et 55% en poids en magnésium, ladite proportion initiale étant maintenue constante au cours du dépôt par le biais de moyens d'ajustement de la composition du bain d'alliage métallique comprenant des moyens d'alimentation des moyens d'évaporation (3,13) en alliage métallique fondu de composition contrôlée.

2. Procédé selon la revendication 1, selon lequel on dépose en continu sur ledit substrat une couche d'alliage métallique à base de zinc et comprenant une proportion de magnésium prédéterminée comprise entre 4% et 18% en poids, par évaporation d'un bain d'alliage métallique à base de zinc et comprenant initialement une proportion de magnésium prédéterminée entre 30% et 50% en poids en magnésium, ladite proportion initiale étant maintenue constante au cours du dépôt.

3. Procédé selon l'une quelconque des revendications 1 ou 2, selon lequel on dépose une couche d'alliage métallique en une épaisseur comprise entre 0,1 et 20 µm.

4. Procédé selon l'une quelconque des revendications 1 à 3, selon lequel ledit substrat (S) est une bande métallique et de préférence une bande d'acier.

5. Procédé selon la revendication 4, selon lequel ladite bande métallique est un acier à durcissement par cuisson (bake-hardening).

6. Installation de dépôt sous vide en continu (1, 21) de revêtements formés d'alliages métalliques comprenant au moins deux éléments métalliques sur un substrat (S) en défilement, comprenant une enceinte de dépôt sous vide (2) et des moyens de défilement dudit substrat (S) au sein de cette enceinte (2), ladite installation (1, 21) comprenant en outre :
- un dispositif de revêtement par jet de vapeur sonique (7) et
- des moyens d'alimentation dudit dispositif de revêtement (7) en vapeur comprenant lesdits au moins deux éléments métalliques dans un rapport prédéterminé et constant,
- des moyens d'évaporation (3) d'un bain d'alliage métallique comprenant lesdits éléments métalliques, venant alimenter ledit dispositif de revêtement (7) et qui sont constitués d'un creuset d'évaporation (3) muni de moyens de chauffage et lesdits moyens d'alimentation dudit creuset d'évaporation (3) en alliage métallique fondu de composition contrôlée comprennent un four de rechargement (5) relié à des moyens d'alimentation en lingots métalliques et muni d'un système de chauffage, ledit four de rechargement (5) étant relié au creuset d'évaporation (3) qu'il alimente,
- des moyens d'ajustement de la composition du bain d'alliage métallique permettant de la maintenir constante au cours du temps et qui comprennent des moyens d'alimentation des moyens d'évaporation (3) en alliage métallique fondu de composition contrôlée,
- des moyens de circulation en continu du bain sous la forme d'une conduite de recirculation (6) reliant ledit creuset d'évaporation (3) et ledit four de rechargement (5),
ledit creuset d'évaporation (3) étant placé dans ladite enceinte sous vide (2) et ledit four de rechargement (5) étant placé en-dehors de ladite enceinte sous vide (2).

7. Installation de dépôt sous vide en continu (11,21) de revêtements formés d'alliages métalliques comprenant au moins deux éléments métalliques sur un substrat (S) en défilement, comprenant une enceinte de dépôt sous vide (12) et des moyens de défilement dudit substrat (S) au sein de cette enceinte (12), ladite installation (11,21) comprenant en outre :
- un dispositif de revêtement par jet de vapeur sonique (17) et
- des moyens d'alimentation dudit dispositif de revêtement (17) en vapeur comprenant lesdits au moins deux éléments métalliques dans un rapport prédéterminé et constant,
- des moyens d'évaporation (13) d'un bain d'alliage métallique comprenant lesdits éléments métalliques, venant alimenter ledit dispositif de revêtement (17) et qui sont constitués d'un creuset d'évaporation (13) muni de moyens de chauffage et lesdits moyens d'alimentation dudit creuset d'évaporation (13) en alliage métallique fondu de composition contrôlée comprennent un four de rechargement (15) relié à des moyens d'alimentation en lingots métalliques et muni d'un système de chauffage, ledit four de rechargement (15) étant relié au creuset d'évaporation (13) qu'il alimente,
- des moyens d'ajustement de la composition du bain d'alliage métallique permettant de la maintenir constante au cours du temps et qui comprennent des moyens d'alimentation des moyens d'évaporation (13) en alliage métallique fondu de composition contrôlée,
dans laquelle ledit four de rechargement (15) et ledit creuset d'évaporation (13) sont disposés côte à côte et présentent une paroi commune (16) percée d'au moins une ouverture (19) située sous le niveau du bain d'alliage métallique et au-dessus du fond desdits four (15) et creuset (13) et dans laquelle ledit creuset d'évaporation (13) est placé dans une enceinte confinée (18) et ledit four de rechargement (15) est placé en dehors de ladite enceinte confinée (18).

## Patentansprüche

1. Verfahren zur Beschichtung eines Substrats (S), wobei eine Metalllegierungsschicht auf Zinkbasis, die einen vorbestimmten Magnesiumanteil zwischen 4 und 20 Gew.-% umfasst, mittels einer Vakuumabscheidungsanlage (1, 11, 21) kontinuierlich auf das Substrat (S) abgeschieden wird, wobei die Vakuumabscheidungsanlage (1, 11, 21) eine Dampfstrahlbeschichtungsvorrichtung (7, 17) umfasst, die eine Beaufschlagung des Substrats (S) mit einem Dampf bei Schallgeschwindigkeit ermöglicht, wobei der Dampf durch Verdampfung eines Metallbades auf Zinkbasis gewonnen wird, das anfänglich einen vorbestimmten Magnesiumanteil zwischen 30 und 55 Gew.-% Magnesium umfasst, wobei der anfängliche Anteil im Verlauf der Abscheidung durch Einrichtungen zur Einstellung der Zusammensetzung des Metalllegierungsbades konstant gehalten wird, welche Einrichtungen zur Versorgung der Verdampfungseinrichtungen (3, 13) mit kontrolliert zusammengesetzter geschmolzener Metalllegierung umfassen.

2. Verfahren nach Anspruch 1, wobei eine Metalllegierungsschicht auf Zinkbasis, die einen vorbestimmten Magnesiumanteil zwischen 4 und 18 Gew.-% umfasst, durch Verdampfung eines Metalllegierungsbades auf Zinkbasis, das anfänglich einen vorbestimmten Magnesiumanteil zwischen 30 und 50 Gew.-% Magnesium umfasst, kontinuierlich auf das Substrat abgeschieden wird, wobei der anfängliche Anteil im Verlauf der Abscheidung konstant gehalten wird.

3. Verfahren nach einem der Ansprüche 1 oder 2, wobei eine Metalllegierungsschicht in einer Dicke zwischen 0,1 und 20 µm abgeschieden wird.

4. Verfahren nach einem der Ansprüche 1 bis 3, wobei das Substrat (S) ein Metallband und vorzugsweise ein Stahlband ist.

5. Verfahren nach Anspruch 4, wobei das Metallband ein Bake-Hardening-Stahl ist.

6. Anlage (1, 21) zur kontinuierlichen Vakuumabscheidung von aus Metalllegierungen gebildeten Beschichtungen, die mindestens zwei metallische Elemente umfassen, auf ein durchlaufendes Substrat (S), umfassend ein Vakuumabscheidungsgehäuse (2) und Einrichtungen zum Fördern des Substrats (S) in dem Gehäuse (2), wobei die Anlage (1, 21) des Weiteren Folgendes umfasst:
- eine Schalldampfstrahlbeschichtungsvorrichtung (7) und
- Einrichtungen zur Versorgung der Beschichtungsvorrichtung (7) mit Dampf, der die mindestens zwei metallischen Elemente in einem vorbestimmten und konstanten Verhältnis umfasst,
- Einrichtungen (3) zur Verdampfung eines die metallischen Elemente umfassenden Metalllegierungsbades zur Versorgung der Beschichtungsvorrichtung (7), welche aus einem mit Heizeinrichtungen versehenen Verdampfungstiegel (3) gebildet sind, wobei die Einrichtungen zur Versorgung des Verdampfungstiegels (3) mit kontrolliert zusammengesetzter geschmolzener Metalllegierung einen Nachladeofen (5) umfassen, der mit Einrichtungen zur Versorgung mit Metallbarren verbunden und mit einem Heizsystem versehen ist, wobei der Nachladeofen (5) mit dem durch ihn versorgten Verdampfungstiegel (3) verbunden ist,
- Einrichtungen zur Einstellung der Zusammensetzung des Metalllegierungsbades, die es ermöglichen, die Zusammensetzung im Lauf der Zeit konstant zu halten, und Einrichtungen zur Versorgung der Verdampfungseinrichtungen (3) mit kontrolliert zusammengesetzter geschmolzener Metalllegierung umfassen,
- Einrichtungen zur kontinuierlichen Zirkulation des Bades in Form einer Zirkulationsleitung (6), die den Verdampfungstiegel (3) und den Nachladeofen (5) miteinander verbindet,
wobei der Verdampfungstiegel (3) innerhalb des Vakuumgehäuses (2) angeordnet ist und der Nachladeofen (5) außerhalb des Vakuumgehäuses (2) angeordnet ist.

7. Anlage (11, 21) zur kontinuierlichen Vakuumabscheidung von aus Metalllegierungen gebildeten Beschichtungen, die mindestens zwei metallische Elemente umfassen, auf ein durchlaufendes Substrat (S), umfassend ein Vakuumabscheidungsgehäuse (12) und Einrichtungen zum Fördern des Substrats (S) in dem Gehäuse (12), wobei die Anlage (11, 21) des Weiteren Folgendes umfasst:
- eine Schalldampfstrahlbeschichtungsvorrichtung (17) und
- Einrichtungen zur Versorgung der Beschichtungsvorrichtung (17) mit Dampf, der die mindestens zwei metallischen Elemente in einem vorbestimmten und konstanten Verhältnis umfasst,
- Einrichtungen (13) zur Verdampfung eines die metallischen Elemente umfassenden Metalllegierungsbades zur Versorgung der Beschichtungsvorrichtung (17), welche aus einem mit Heizeinrichtungen versehenen Verdampfungstiegel (13) gebildet sind, wobei die Einrichtungen zur Versorgung des Verdampfungstiegels (13) mit kontrolliert zusammengesetzter geschmolzener Metalllegierung einen Nachladeofen (15) umfassen, der mit Einrichtungen zur Versorgung mit Metallbarren verbunden und mit einem Heizsystem versehen ist, wobei der Nachladeofen (15) mit dem durch ihn versorgten Verdampfungstiegel (13) verbunden ist,
- Einrichtungen zur Einstellung der Zusammensetzung des Metalllegierungsbades, die es ermöglichen, die Zusammensetzung im Laufe der Zeit konstant zu halten, und Einrichtungen zur Versorgung der Verdampfungseinrichtungen (13) mit kontrolliert zusammengesetzter geschmolzener Metalllegierung umfassen,
wobei der Nachladeofen (15) und der Verdampfungstiegel (13) nebeneinander angeordnet sind und eine gemeinsame Wand (16) aufweisen, die von einer unterhalb des Metalllegierungsbades und oberhalb des Bodens des Ofens (15) und des Tiegels (13) angeordneten Öffnung (19) durchgriffen ist, und wobei der Verdampfungstiegel (13) innerhalb eines geschlossenen Gehäuses (18) angeordnet ist und der Nachladeofen (15) außerhalb des geschlossenen Gehäuses (18) angeordnet ist.

## Claims

1. Method of coating a substrate (S) according to which there is continuously deposited on said substrate (S) a layer of metal alloy based on zinc and comprising a predetermined proportion of magnesium of from 4% to 20% by weight by means of a vacuum deposition installation (1, 11, 21) comprising a device (7, 17) for coating using a vapour jet that makes it possible to project onto the substrate (S), at a sonic velocity, a vapour obtained by evaporation of a metal bath based on zinc and comprising initially a predetermined proportion of magnesium of from 30% to 55% by weight of magnesium, said initial proportion being kept constant in the course of deposition by way of means for adjustment of the composition of the bath of metal alloy which comprise means for supplying the evaporation means (3, 13) with molten metal alloy of controlled composition.

2. Method according to claim 1, according to which there is continuously deposited on said substrate a layer of metal alloy based on zinc and comprising a predetermined proportion of magnesium of from 4% to 18% by weight by evaporation of a bath of metal alloy based on zinc and comprising initially a predetermined proportion of magnesium of from 30% to 50% by weight of magnesium, said initial proportion being kept constant in the course of deposition.

3. Method according to any one of claims 1 or 2, according to which there is deposited a layer of metal alloy in a thickness of from 0.1 to 20 µm.

4. Method according to any one of claims 1 to 3, according to which said substrate (S) is a metal strip and preferably a steel strip.

5. Method according to claim 4, according to which said metal strip is a bake-hardening steel.

6. Installation (1, 21) for continuous vacuum deposition of coatings formed of metal alloys comprising at least two metal elements on a substrate (S) passing through, comprising a vacuum deposition enclosure (2) and means for passing said substrate (S) through that enclosure (2), said installation (1, 21) additionally comprising:
- a device (7) for coating by means of a sonic vapour jet and
- means for supplying said coating device (7) with vapour comprising said at least two metal elements in a predetermined and constant ratio,
- means (3) for evaporating a bath of metal alloy comprising said metal elements, which then supply said coating device (7), and which are composed of an evaporation crucible (3) provided with heating means, and said means for supplying said evaporation crucible (3) with molten metal alloy of controlled composition comprise a replenishing oven (5) connected to means for supplying metal ingots and provided with a heating system, said replenishing oven (5) being connected to the evaporation crucible (3) which it supplies,
- means for adjusting the composition of the bath of metal alloy which make it possible to keep it constant over time and which comprise means for supplying the evaporation means (3) with molten metal alloy of controlled composition,
- means for continuous circulation of the bath in the form of a recirculation pipe (6) connecting said evaporation crucible (3) and said replenishing oven (5),
said evaporation crucible (3) being located within said vacuum enclosure (2) and said replenishing oven (5) being located outside said vacuum enclosure (2).

7. Installation (11, 21) for continuous vacuum deposition of coatings formed of metal alloys comprising at least two metal elements on a substrate (S) passing through, comprising a vacuum deposition enclosure (12) and means for passing said substrate (S) through that enclosure (12), said installation (11, 21) additionally comprising:
- a device (17) for coating by means of a sonic vapour jet and
- means for supplying said coating device (17) with vapour comprising said at least two metal elements in a predetermined and constant ratio,
- means (13) for evaporating a bath of metal alloy comprising said metal elements, which then supply said coating device (17), and which are composed of an evaporation crucible (13) provided with heating means, and said means for supplying said evaporation crucible (13) with molten metal alloy of controlled composition comprise a replenishing oven (15) connected to means for supplying metal ingots and provided with a heating system, said replenishing oven (15) being connected to the evaporation crucible (13) which it supplies,
- means for adjusting the composition of the bath of metal alloy which make it possible to keep it constant over time and which comprise means for supplying the evaporation means (13) with molten metal alloy of controlled composition,
wherein said replenishing oven (15) and said evaporation crucible (13) are arranged side by side and have a common wall (16) through which there passes at least one aperture (19) located below the level of the bath of metal alloy and above the bottoms of said oven (15) and said crucible (13), and wherein said evaporation crucible (13) is located within a closed enclosure (18) and said replenishing oven (15) is located outside said closed enclosure (18).
